# EUROPEAN PATENT APPLICATION

(11) **EP 0 866 560 A1**
(43) Date of publication of application: **23.09.1998**
(21) Application number: 98302126.2
(22) Date of filing: 20.03.1998
(51) Int. Cl.: H03L 7/18

(54) **Improved digital clock synthesizer**

(30) Priority: 21.03.1997 US 822964
(71) Applicant: TEKTRONIX, INC., Wilsonville, Oregon 97070-1000 (US)
(72) Inventor: Crosby, Philip S., Portland, Oregon 97219 (US)
(74) Representative: Molyneaux, Martyn William

(57) **Abstract**

An improved digital clock synthesizer provides an "inside-out" topology. A reference signal is used as one input to a phase-locked loop (PLL) that produces a clock signal, the reference signal being an integer multiple of the clock signal. A direct digital signal synthesizer, having a phase increment defined by a first constant, is driven by the clock signal to produce a constant synthesized frequency signal. A narrow-band reconstruction filter is used to filter the synthesized frequency signal, which provides the other frequency signal for input to the phase-locked loop.

## Description

### CROSS-REFERENCE TO RELATED APPLICATION

Not applicable

### STATEMENT REGARDING FEDERALLY SPONSORED RESEARCH OR DEVELOPMENT

Not applicable

### BACKGROUND OF THE INVENTION

The present invention relates to digital clock generation, and more particularly to an improved digital clock synthesizer that has an "inside-out" topology.

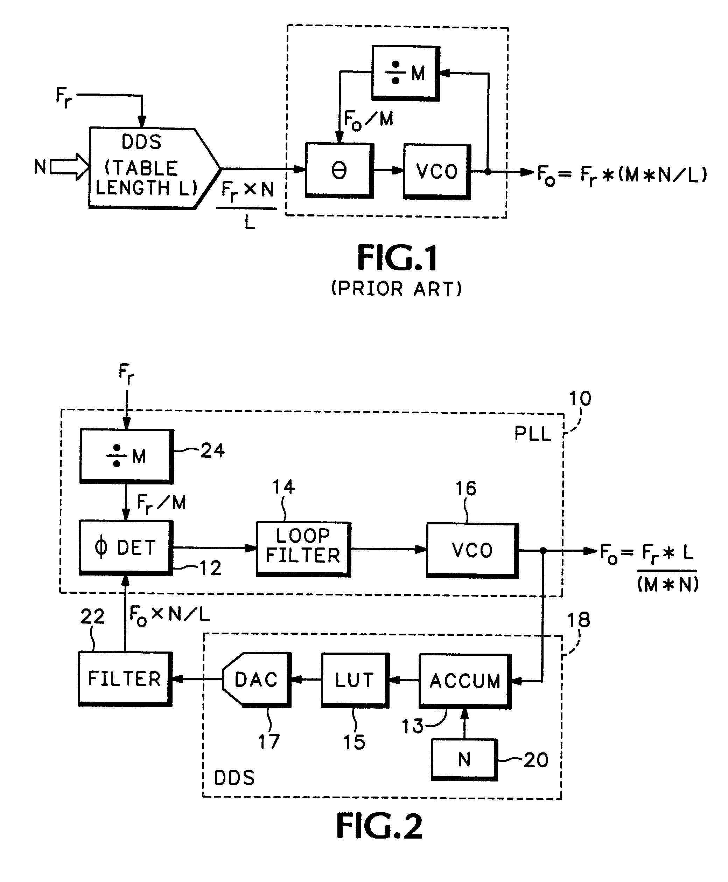

As shown in Fig. 1 normally a reference clock, **Fr,** is used as a clock source for a direct digital signal synthesizer (DDS), such as the Analog Devices AD7008 DDS Modulator which has a numerically controlled oscillator using a phase accumulator, sine/cosine look-up tables having a length **L** and a digital to analog (D/A) converter. The DDS outputs a stepwise analog sinewave that is filtered to produce a smooth analog sinewave which is then used as an input for a multiplying phase-locked loop (PLL), such as the Integrated Circuit Systems, Inc. AV9170 Clock Synchronizer and Multiplier.
- **Fr*N/L** =: output of the DDS
- **M** =: PLL multiplying factor
where N and M are integer constants. The inputs to the phase detector/comparator of the PLL are **Fr*N/L** from the DDS and **Fo/M**. Therefore the output of a voltage controlled oscillator in the PLL, **Fo**, is **Fr * M*N/L.** The term that has the finest resolution is generally **N**, since it has at least the table length and whatever fractional bits there are as its numerator. Since the output frequency of the conventional DDS varies as **N**, the filtering is done using a wideband reconstruction filter.

What is desired is an improved digital clock synthesizer wherein the frequency generated by a DDS is constant, eliminating the need for an expensive, wideband reconstruction filter.

### BRIEF SUMMARY OF THE INVENTION

Accordingly the present invention provides an improved direct digital clock synthesizer that divides a reference clock, **Fr,** by a factor **M**, and feeds the resultant divided signal, **Fr/M**, to a phase detector/comparator in a phase-locked loop (PLL). The frequency output by the PLL is the synthesized clock signal, **Fo**, which also is used as a clock signal for a direct digital signal synthesizer (DDS). Also input to the DDS is a numerical control constant, **N**, so that the output of the DDS is a constant synthesized signal, **Fo*N/L.** The synthesized signal is filtered by a narrow-band reconstruction filter to produce a smooth analog signal that is input to the phase detector/comparator of the PLL. The phase detector/comparator provides an inverted phase detector signal that is used to control a voltage controlled oscillator (VCO) via a loop filter to provide the synthesized clock signal from the PLL. The synthesized clock signal has a frequency, **Fo = Fr *L/(M*N).**

The objects, advantages and other novel features of the present invention are apparent from the following detailed description when read in conjunction with the appended claims and attached drawing.

### BRIEF DESCRIPTION OF THE SEVERAL VIEWS OF THE DRAWING

Fig. 1 is a block diagram view of a digital clock synthesizer according to the prior art.

Fig. 2 is a block diagram view of an improved digital clock synthesizer according to the present invention.

### DETAILED DESCRIPTION OF THE INVENTION

Referring now to the Fig.2 a phase-locked loop (PLL) **10** includes a phase detector/comparator **12**, a loop filter **14** and a voltage controlled oscillator (VCO) **16** in series. The frequency signal output from the VCO, **Fo**, is a synthesized clock signal that also is used to clock a direct digital signal synthesizer (DDS) **18** which has as an input a numerical control constant, **N**, stored in a programmable register **20**. The DDS **18** includes a phase accumulator **13**, a sine/cosine look-up table **15** of length **L** and a digital to analog converter (DAC) **17** coupled in series. The frequency output from a narrow-band reconstruction filter **22** at the output of the DDS **18** provides one input to the phase detector/comparator **12**. The other input is a frequency from a divider **24** in the PLL **10** having a divisor of **M.** The input to the divider **24** is a reference frequency, **Fr**. The phase detector signal from the phase detector/comparator **12** is reversed prior to input to the loop filter **14** since, unlike the prior art where the reference is the output of the DDS, the reference is **Fr/M** in the PLL **10**. Since the action of the PLL **10** ensures that the frequencies of the two inputs to the phase detector **12** are equal, the output frequency, **Fo**, is constrained to be equal to **Fr * L/(M*N)** where **L/(M*N)** is a constant, i.e., **Fo = I*Fr**.

Since the output from the DDS **18** is a constant frequency, the reconstruction filter **22** need only be an inexpensive narrow band filter. Also the clock generator and all circuits driven by the clock signal are synchronized since the output of the PLL **10** is used both as a system clock and the input clock for the DDS **18**. Therefore, for example, the same state machine may communicate with the DDS as communicates with other circuitry driven by the clock.

Thus the present invention provides an improved digital clock synthesizer by combining a phase-locked loop with a direct digital signal synthesizer in an "inside-out" topology, a reference signal being used as input to the frequency multiplying phase-locked loop and the output clock from the phase-locked loop also being used to clock the direct digital signal synthesizer.

## Claims

1. A digital clock synthesizer for generating a clock signal comprising:
a phase-locked loop having as one input a reference frequency signal and providing as an output the clock signal;
a direct digital signal synthesizer having the clock signal coupled to one input and a first constant coupled to a second input, and providing as an output a synthesized frequency signal; and
a narrow-band reconstruction filter having as an input the synthesized frequency signal and having an output coupled to a second input of the phase-locked loop.

2. The digital clock synthesizer as recited in claim 2 wherein the phase-locked loop comprises:
a divider circuit having the reference frequency signal as an input for dividing the reference frequency signal by a second constant and providing as an output a divided reference frequency signal;
a phase detector having as one input the divided reference frequency signal and having a second input coupled to the output of the narrow-band filter, and providing as an output a voltage control signal; and
a voltage controlled oscillator having an input coupled to the output of the phase detector to receive the voltage control signal and providing the clock signal as an output.

3. The digital clock synthesizer as recited in claim 2 wherein the voltage control signal is an inverted control signal from the phase detector.

4. A digital clock synthesizer comprising:
a phase-locked loop having first and second frequency signals as inputs and providing a clock signal as an output;
means for deriving the first frequency signal from a reference frequency signal such that the reference clock signal is an integer multiple of the clock signal; and
means for digitally generating the second frequency signal in response to the clock signal and a first constant.

5. The digital signal synthesizer as recited in claim 4 wherein the digitally generating means comprises:
a direct digital signal synthesizer having as inputs the clock signal and the first constant and providing a synthesized frequency signal as an output; and
a narrow-band reconstruction filter having as an input the synthesized frequency signal and as an output the second frequency signal.

6. A method of digital clock synthesization comprising the steps of:
generating a direct digital synthesized frequency signal from a clock signal and a first constant; and
generating the clock signal from a reference frequency signal and the direct digital synthesized frequency signal, where the reference frequency signal is an integer multiple of the clock signal.

7. The method as recited in claim 6 wherein the synthesized frequency signal generating step includes the steps of:
direct digital synthesizing a digital frequency signal from the clock signal and the first constant; and
narrow-band filtering the digital frequency signal to produce the synthesized frequency signal.
